# FASCICULE DE BREVET EUROPEEN

(11) **EP 2 416 181 B1**
(45) Date de publication et mention de la délivrance du brevet: **17.10.2018**
(21) Numéro de dépôt: 11174702.8
(22) Date de dépôt: 20.07.2011
(51) Int. Cl.: G01V 3/08, H03K 17/945

(54) **Procédé de détection d'objet au moyen d'un capteur de proximité**
Objekterkennungsverfahren mit Hilfe eines Näherungssensors
Method of detecting an object by means of a proximity sensor

(30) Priorité: 04.08.2010 FR 1003270
(43) Date de publication de la demande: 08.02.2012
(73) Titulaire: STMicroelectronics Rousset SAS, 13790 Rousset (FR)
(72) Inventeur: Teissier, Maxime, 13100 Aix en Provence (FR); Troise, Cyril, 13009 Marseille (FR)
(74) Mandataire: Casalonga

(56) Documents cités:
- EP-A1- 2 187 241
- EP-A2- 2 037 582
- US-A1- 2006 267 953
- US-A1- 2009 273 340
- US-A1- 2010 060 270

## Description

La présente invention concerne un procédé de détection d'objet au moyen d'un signal de détection fourni par un capteur de proximité.

La présente invention concerne notamment les détecteurs d'objet comprenant un capteur de proximité de type capacitif.

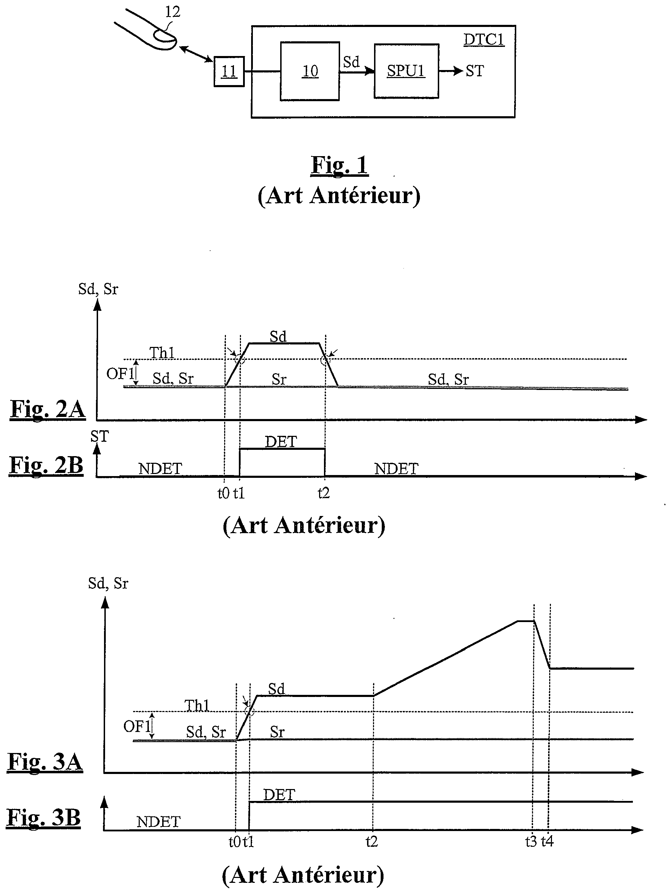

La figure 1 représente schématiquement un détecteur de proximité DTC1 classique. Le détecteur DTC1 comprend un capteur de proximité 10 et une unité SPU1 de traitement de signal. Le capteur 10 comporte une partie sensible 11 et des moyens électroniques de contrôle et de lecture de la partie sensible 11, fournissant un signal de détection Sd. Le signal Sd présente une valeur, par exemple son amplitude, qui varie en fonction de la distance séparant un objet 12 de la partie sensible 11. La valeur du signal Sd évolue également en fonction de divers paramètres environnementaux tels que la température, la constante diélectrique de l'air qui est fonction de l'humidité ambiante, la proximité d'objets autres que l'objet détecté, etc.

L'unité SPU1 assure le traitement du signal Sd et fournit un signal d'état ST présentant deux valeurs DET et NDET, signifiant respectivement "objet détecté" ou "objet non détecté".

Un procédé classique de traitement du signal Sd tel qu'exécuté par l'unité SPU1 est illustré sur les figures 2A, 2B. On suppose ici que le signal Sd présente une valeur croissante lorsque l'objet se rapproche du capteur 10. Le procédé comprend les étapes suivantes :
- l'unité SPU1 calcule un signal de référence Sr dont la valeur varie plus lentement que celle du signal Sd, par exemple par filtrage passe-bas du signal Sd,
- l'unité SPU1 définit un seuil de détection Th1 supérieur au signal de référence Sr, par exemple en ajoutant un offset OF1 à la valeur du signal de référence Sr,
- quand la valeur du signal Sd devient supérieure au seuil Th1, l'unité SPU1 passe de l'état de non-détection NDET à l'état de détection DET et bloque la valeur du signal de référence Sr,
- quand la valeur du signal Sd redevient inférieure au seuil Th1, l'unité SPU1 repasse dans l'état de non-détection NDET, et libère le signal de référence Sr. Celui-ci est alors de nouveau généré dynamiquement par filtrage du signal Sd.

Dans l'exemple représenté sur la figure 2A, le signal Sd commence à croître à un instant t0 et atteint le seuil Th1 à un instant t1. Le signal Sr ne varie pas de manière perceptible entre t0 et t1 car il ne recopie que les variations lentes du signal Sd. Le signal Sr est ensuite verrouillé (i.e. gelé) à partir de l'instant t1 jusqu'à un instant t2 où le signal Sd redevient inférieur à Th1. Après l'instant t2, le signal Sr ne varie toujours pas de manière perceptible car il ne recopie pas le front descendant de courte durée du signal Sd.

Dans une variante de ce procédé, le capteur 10 fournit un signal Sd dont la valeur décroît lorsque l'objet 12 se rapproche du capteur. Le seuil de détection Th1 est dans ce cas choisi inférieur au signal de référence Sr et le détecteur passe dans l'état de détection DET lorsque la valeur du signal Sd devient inférieure au seuil Th1.

Dans un tel procédé, le verrouillage du signal de référence Sr permet d'empêcher celui-ci de rejoindre lentement le signal de détection Sd, ce qui provoquerait un retour indésirable à l'état de non-détection. En effet, le seuil Th1 augmenterait avec le signal Sr et le signal de détection Sd se retrouverait, à un moment ou à un autre, inférieur au seuil Th1.

Un tel procédé de détection s'avère satisfaisant lorsque le temps de détection d'un objet est réduit. Toutefois, dans certaines applications où le temps de détection d'un objet peut être important, une modification des paramètres environnementaux pendant la période de détection d'objet peut conduire à un blocage du détecteur.

Les figures 3A, 3B illustrent ce problème. La valeur du signal Sd commence à croître à un instant t0 et atteint le seuil Th1 à l'instant t1, provoquant le verrouillage du signal Sr (Fig. 3A). Le détecteur passe de l'état de non-détection NDET à l'état de détection DET (Fig. 3B). A un instant t2, les paramètres environnementaux changent et provoquent une nouvelle croissance de la valeur du signal Sd, qui n'est pas liée à un déplacement de l'objet. A un instant t3, l'objet quitte le champ de détection du capteur ou cesse d'être au contact du capteur, s'il s'agit d'un capteur. La valeur du signal Sd diminue pour atteindre, à un instant t4, une valeur inférieure représentative de l'état de non-détection. Cette valeur inférieure est toutefois supérieure au seuil Th1 en raison du changement des paramètres environnementaux. Le détecteur reste alors bloqué dans l'état de détection.

Ce problème a par exemple été constaté dans les applications suivantes :
- Un détecteur de proximité est intégré dans le casque d'un baladeur audionumérique. Le détecteur permet de couper automatiquement le son lorsque l'utilisateur ne porte pas le casque. On a constaté que la formation ou le dépôt d'humidité sur la surface sensible du capteur, par exemple sous l'effet de la transpiration de l'utilisateur, fait croître la valeur du signal de détection Sd. Lorsque l'utilisateur retire le casque, la valeur du signal Sd reste élevée, comme montré sur la figure 3A, et le détecteur de proximité reste dans l'état de détection.
- Un détecteur de proximité est intégré dans un téléphone mobile équipé d'un clavier tactile. Le détecteur est utilisé pour verrouiller le clavier tactile et/ou mettre l'écran en mode basse consommation pendant une conversation téléphonique, lorsque l'utilisateur approche le téléphone de ses oreilles. On a également constaté que le détecteur peut se bloquer dans l'état de détection après dépôt ou formation d'humidité sur la partie sensible du capteur. Cela peut se produire pendant une conversation téléphonique ou du fait que le téléphone a brutalement changé d'environnement (par exemple après avoir été placé dans une pièce humide comme une salle de bains). Dans ce cas, le clavier tactile reste verrouillé de manière intempestive, empêchant l'utilisateur de se servir du téléphone.

Le document EP 2 187 241 décrit un procédé de détection d'objet au moyen d'un signal de détection fourni par un capteur de proximité dans lequel les signaux dépendent des facteurs de l'environnement où le capteur de proximité est installé. Les valeurs des signaux sont fixées une par une après détermination des facteurs correspondants. Le document EP 2 037 582 décrit un procédé de détection d'objet au moyen d'un signal de détection fourni par un capteur de proximité dans lequel des signaux de référence sont générés par filtrage de la valeur du signal de détection avec le but d'avoir des signaux de référence initiaux. Dans le document US 2006/267983 des variations lentes des signaux sont traitées comme des effets dus à des paramètres environnementaux. Dans les cas des variations rapides on détecte la présence d'un objet.

Il peut donc être souhaité de prévoir un procédé de détection d'objet qui soit plus résistant aux variations de paramètres environnementaux affectant le signal de détection.

Les problèmes mentionnés sont résolus avec les caractéristiques selon les revendications 1, 13 et 14.

Des modes de réalisation de l'invention concernent un procédé de détection d'objet au moyen d'un signal de détection fourni par un capteur de proximité, le signal de détection présentant une valeur qui croit, ou respectivement décroît, en fonction de la proximité d'un objet détecté, procédé comprenant des étapes consistant à : générer un signal de référence par filtrage de la valeur du signal de détection; définir un premier seuil de détection relativement au signal de référence ; passer d'un état de non-détection d'objet à un état de détection d'objet lorsque la valeur du signal de détection devient supérieure, ou respectivement inférieure, au premier seuil de détection ; et lorsque la valeur du signal de détection devient supérieure, ou respectivement inférieure, au premier seuil de détection, réajuster la valeur du signal de référence de manière que la valeur du signal de détection redevienne inférieure, ou respectivement supérieure, au premier seuil de détection.

Selon un mode de réalisation, le procédé comprend une étape consistant à réajuster de nouveau la valeur du signal de référence de manière que la valeur du signal de détection redevienne inférieure, ou respectivement supérieure, au premier seuil de détection, lorsque, dans l'état de détection d'objet, la valeur du signal de détection devient de nouveau supérieure, ou respectivement inférieure, au premier seuil de détection.

Selon un mode de réalisation, le procédé comprend les étapes consistant à définir un second seuil de détection relativement au signal de référence ; passer de l'état de détection d'objet à l'état de non-détection d'objet lorsque la valeur du signal de détection devient inférieure, ou respectivement supérieure, au second seuil de détection ; et lorsque la valeur du signal de détection devient inférieure, ou respectivement supérieure, au second seuil de détection, réajuster la valeur du signal de référence de manière que la valeur du signal de détection redevienne supérieure, ou respectivement inférieure, au second seuil de détection.

Selon un mode de réalisation, le procédé comprend une étape consistant à réajuster de nouveau la valeur du signal de référence de manière que la valeur du signal de détection redevienne supérieure, ou respectivement inférieure, au second seuil de détection, lorsque, dans l'état de non-détection d'objet, la valeur du signal de détection devient de nouveau inférieure, ou respectivement supérieure, au second seuil de détection, sans modifier l'état de non-détection.

Selon un mode de réalisation, le second seuil de détection est égal à la valeur du signal de référence à laquelle est soustrait un offset, ou respectivement à laquelle est ajouté un offset.

Selon un mode de réalisation, le premier seuil de détection est égal à la valeur du signal de référence à laquelle est ajouté un offset, ou respectivement à laquelle est soustrait un offset.

Selon un mode de réalisation, le réajustement de la valeur du signal de référence est conduit de manière que la valeur du signal de détection soit sensiblement égale à la valeur du signal de référence avec une déviation maximale inférieure à l'écart entre la valeur du signal de référence réajusté et le seuil de détection dont le franchissement provoque le réajustement du signal de référence.

Selon un mode de réalisation, le réajustement de la valeur du signal de référence est réalisé à partir de valeurs du signal de détection postérieures à l'instant où la valeur du signal de détection devient supérieure ou inférieure au seuil.

Selon un mode de réalisation, la valeur du signal de détection est une amplitude, une fréquence, une phase, une durée ou un nombre.

Selon un mode de réalisation, l'étape consistant à passer de l'état de détection d'objet à l'état de non-détection d'objet ou vice-versa, comprend une étape consistant à modifier la valeur d'un signal d'état ou d'un registre d'état.

Selon un mode de réalisation, l'objet à détecter est une partie du corps humain.

Selon un mode de réalisation, le signal de détection est fourni par un capteur de proximité capacitif.

Des modes de réalisation de l'invention concernent également un produit-programme d'ordinateur, comprenant un code exécutable enregistré sur un support pour la mise en oeuvre du procédé selon l'invention.

Des modes de réalisation de l'invention concernent également un détecteur de proximité comprenant un capteur de proximité fournissant un signal de détection présentant une valeur qui croît, ou respectivement décroît, lorsqu'un objet se rapproche du capteur ou touche le capteur ; une unité de traitement, à microprocesseur ou à logique câblée, recevant le signal de détection ; et dans lequel l'unité de traitement est configurée pour mettre en oeuvre le procédé selon l'invention.

Des modes de réalisation de l'invention concernent également un dispositif portatif présentant au moins un organe pouvant être activé et désactivé, le dispositif comprenant au moins un détecteur selon l'invention et étant configuré pour activer ou désactiver l'organe lorsqu'un objet est détecté à proximité du dispositif.

Des modes de réalisation du procédé de détection d'objet selon l'invention et d'un détecteur d'objet selon l'invention seront décrits dans ce qui suit en se référant à titre non limitatif aux figures jointes parmi lesquelles :
- la figure 1 précédemment décrite représente schématiquement un détecteur d'objet classique,
- les figures 2A, 2B précédemment décrites représentent des signaux apparaissant dans le détecteur en l'absence de variation de paramètres environnementaux,
- les figures 3A, 3B précédemment décrites représentent un second exemple de signaux apparaissant dans le détecteur en présence d'une variation de paramètres environnementaux,
- la figure 4 représente schématiquement un détecteur configuré pour mettre en oeuvre le procédé de l'invention,
- la figure 5 est un organigramme décrivant un mode de réalisation du procédé de l'invention,
- les figures 6A, 6B représentent des signaux apparaissant dans le détecteur de la figure 4 en l'absence de variation de paramètres environnementaux,
- les figures 7A, 7B représentent des signaux apparaissant dans le détecteur de la figure 4 en présence d'une variation de paramètres environnementaux,
- la figure 8 est un organigramme décrivant un second mode de réalisation du procédé de l'invention, et
- la figure 9 représente schématiquement un objet portatif comprenant un détecteur selon l'invention.

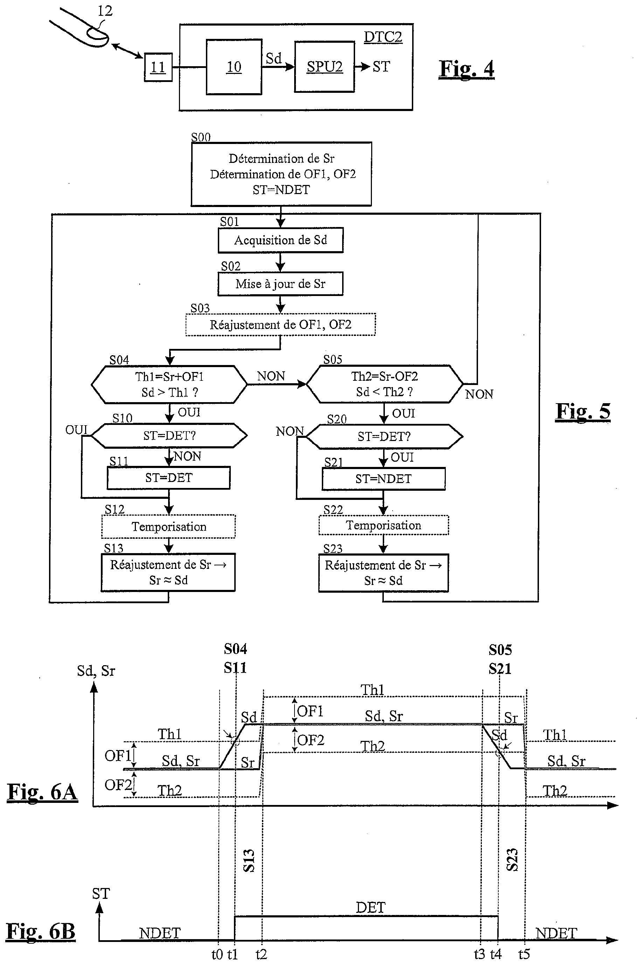

La figure 4 représente schématiquement un détecteur DTC2 configuré pour mettre en oeuvre un mode de réalisation du procédé de détection d'objet selon l'invention. Le détecteur DTC2 comprend un capteur de proximité 10, par exemple de type capacitif, et une unité de traitement SPU2. Le capteur 10 comporte une partie sensible 11 et des moyens électroniques de contrôle et de lecture de la partie sensible, fournissant un signal de détection Sd sous forme analogique ou numérique. Le signal Sd présente une valeur qui varie entre une valeur minimale Sdmin et une valeur maximale Sdmax en fonction de la distance séparant un objet 12 de la partie sensible 11. Selon le type de capteur utilisé et la structure des moyens électroniques de contrôle, cette valeur peut être une amplitude (en tension ou en courant), une fréquence, une phase, une durée ou un nombre, par exemple un nombre d'impulsions ou de cycles pour transférer une charge électrique.

La valeur du signal Sd dépend également de paramètres environnementaux tels que la température, la constante diélectrique de l'air ou l'humidité ambiante, la proximité d'objets autres que l'objet à détecter, etc.

L'unité SPU1 peut être un circuit analogique, un circuit à logique câblée ou un circuit à microprocesseur ou microcontrôleur. Elle assure le traitement du signal de détection Sd selon le procédé de l'invention et fournit un signal d'état ST présentant deux valeurs DET et NDET, signifiant respectivement "objet détecté" ou "objet non détecté". Le signal d'état ST peut être un signal analogique ou numérique fourni par l'unité SPU1, une valeur dans un registre d'état accessible en lecture, ou les deux.

Un mode de réalisation du procédé selon l'invention est illustré par l'organigramme de la figure 5. On suppose dans cet exemple que la valeur du signal de détection Sd croît lorsqu'un objet à détecter se rapproche de la partie sensible 11 du capteur 10. On suppose également ici que le traitement du signal Sd est effectué par calcul numérique, au moyen d'un processeur agencé dans l'unité de traitement SPU2, équipé d'une mémoire programme non volatile et d'une mémoire de données volatile (non représentées). La mémoire programme reçoit un programme exécutable mettant en oeuvre le procédé. Le signal Sd peut être fourni par le capteur 10 sous forme analogique ou numérique. Dans le premier cas, le signal Sd est échantillonné par l'unité SPU2, avec une fréquence d'échantillonnage Fs. Dans le second cas, il est fourni sous forme numérique par le capteur avec une fréquence de rafraîchissement Fs.

Le procédé comporte une étape d'initialisation S00 et une boucle de détection d'objet comprenant des étapes S01 à S23.

L'étape d'initialisation S00 comprend une étape de détermination d'une valeur initiale d'un signal de référence Sr, une étape de détermination de deux offsets OF1, OF2, et une étape d'initialisation du signal d'état ST.

L'étape de détermination d'une valeur initiale du signal de référence Sr comprend une étape de filtrage du signal de détection Sd. L'unité SPU2 utilise par exemple un filtre numérique passe-bas d'ordre 2 de gain 1 du type à réponse impulsionnelle infinie IRR ("Infinite Impulsion Response"), ayant une constante de temps T1. Cette étape est conduite pendant le temps nécessaire à la réception d'un nombre suffisant de valeurs du signal Sd, par exemple entre 8 et 128 valeurs.

L'étape de détermination des offsets OF1, OF2 peut comprendre une étape de lecture des offset OF1, OF2 dans une zone mémoire où ils sont préenregistrés. Elle peut aussi consister à définir les offsets de manière dynamique, en tenant compte de la valeur du signal de détection Sd, pour ajuster automatiquement la sensibilité du détecteur aux conditions d'utilisation. L'unité SPU2 confère par exemple aux offsets des valeurs plus élevées lorsque la valeur du signal Sd est élevée, et plus faibles lorsque la valeur du signal Sd est faible. A cet effet, l'unité SPU2 peut utiliser une fonction mathématique lui permettant de calculer les offsets en fonction de la valeur du signal Sr. Alternativement, l'unité SPU2 peut utiliser une table de correspondance préenregistrée dans la mémoire du processeur, comprenant un nombre fini de valeurs d'offsets correspondant chacune à une valeur ou à une plage de valeurs du signal de détection.

L'étape d'initialisation du signal d'état ST consiste à mettre celui-ci, par défaut, dans l'état de non-détection NDET.

Une fois que ces étapes préliminaires ont été exécutées, la boucle de détection d'objet est exécutée et est répétée tant que le détecteur DTC2 est actif. Elle comprend des étapes S01, S02, S03, S04, S05, S10, S11, S12, S13, S20, S21, S22 et S23.

A l'étape S01, l'unité SPU2 fait l'acquisition d'une nouvelle valeur du signal Sd, fournie par le capteur 10.

A l'étape S02, l'unité SPU2 met à jour la valeur courante du signal Sr, par filtrage du signal Sd incluant la nouvelle valeur reçue. Cette étape n'est pas nécessairement conduite après chaque acquisition d'une nouvelle valeur du signal Sd et peut être faite toutes les N acquisitions, soit à une fréquence Fs/N.

A l'étape S03, l'unité SPU2 réajuste les offsets OF1, OF2 en tenant compte de la nouvelle valeur du signal Sd. Comme l'étape S02, cette étape n'est pas nécessairement conduite après chaque acquisition d'une nouvelle valeur du signal Sd et peut être faite toutes les M acquisitions de nouvelles valeurs, soit à une fréquence Fs/M, M pouvant être égal à N. Cette étape peut également ne pas être exécutée, si les offsets ne sont pas ajustés dynamiquement.

A l'étape S04, l'unité SPU2 calcule un premier seuil de détection Th1 et détermine si la valeur courante du signal de détection Sd est supérieure au seuil Th1. Le seuil Th1 est calculé en ajoutant l'offset OF1 à la valeur courante du signal de référence Sr, soit Th1=Sr+OF1. Si le signal Sd est supérieur à Th1, l'unité SPU2 va à l'étape S10, sinon à l'étape S05.

A l'étape S05, l'unité SPU2 calcule un second seuil de détection Th2 et détermine si la valeur courante du signal de détection Sd est inférieure au seuil Th2. Le seuil Th2 est calculé en soustrayant l'offset OF2 à la valeur courante du signal Sr, soit Th2=Sr-OF2. Si le signal Sd est inférieur à Th2, l'unité SPU2 va à l'étape S20, sinon retourne à l'étape S01.

A l'étape S10, l'unité SPU2 détermine si le détecteur est dans l'état DET, à savoir si ST=DET. Si la réponse est négative, l'unité SPU2 va à l'étape S11 où elle met le détecteur dans l'état DET, puis va à l'étape S12. Si la réponse est positive, l'unité SPU2 passe directement à l'étape S12.

L'étape S12 est une étape de temporisation optionnelle avant d'exécuter l'étape S13.

A l'étape S13, l'unité SPU2 réajuste le signal Sr puis retourne à l'étape S01. L'étape S13 peut comporter une phase de calcul de réajustement suivie du réajustement proprement dit du signal Sr en fin d'étape S13, comme cela apparaîtra plus loin en relation avec les figures 6A à 7B. Le réajustement peut donc être effectué de manière quasi-instantanée à la fin de l'étape S13, mais pourrait aussi être effectué de manière progressive tout au long de l'étape S13.

A l'étape S20, l'unité SPU2 détermine si le détecteur est dans l'état DET, à savoir si ST=DET. Si la réponse est positive, l'unité SPU2 va à l'étape S21 où elle met le détecteur dans l'état NDET, puis va à l'étape S22. Si la réponse est négative, l'unité SPU2 passe directement à l'étape S22.

L'étape S22 est, comme l'étape S12, une étape de temporisation optionnelle avant l'exécution de l'étape S23.

A l'étape S23, l'unité SPU2 réajuste le signal Sr puis retourne à l'étape S01.

En résumé, l'étape de réajustement S13 ou S23 intervient après que le signal de détection Sd a franchi le seuil Th1 ou Th2. Le franchissement du seuil Th1 provoque également le basculement du détecteur dans l'état DET s'il n'est pas déjà dans cet état (étape S11), et le franchissement du seuil Th2 provoque le basculement du détecteur dans l'état NDET s'il n'est pas déjà dans cet état (étape S21).

L'étape de réajustement du signal Sr vise à faire en sorte que le signal Sd se retrouve de nouveau inférieur au seuil Th1 qu'il a franchi (étape S13) ou de nouveau supérieur au seuil Th2 qu'il a franchi (étape S23).

A cet effet, l'unité de traitement SPU2 essaye de ramener le signal de référence Sr à une valeur aussi proche que possible de celle du signal de détection Sd. Il peut arriver que l'égalité parfaite des deux signaux ne puisse être obtenue en raison de fluctuations rapides du signal Sd pendant la phase de réajustement, liées aux conditions d'utilisation (par exemple la distance entre l'objet détecté et le capteur change sans cesse). Ainsi, en présence de fluctuations du signal Sd, une déviation du signal Sr relativement au signal Sd peut être constatée au terme de l'étape de réajustement. Cette déviation doit en pratique être inférieure à l'écart entre la valeur du signal réajusté Sr et le seuil qui a été franchi, c'est-à-dire inférieure à l'offset OF1 ou OF2.

L'étape de réajustement du signal Sd est de préférence réalisée en s'affranchissant des variations instantanées du signal Sd, comme des oscillations parasites éventuelles, qui pourraient fausser le réajustement du signal Sr. Elle comprend par exemple un calcul de la valeur moyenne du signal Sd, basé sur les valeurs du signal Sd reçues pendant la période de réajustement, soit après le franchissement du seuil Th1 ou Th2. Elle peut également comprendre l'application d'une fonction de filtrage au signal Sd, pour obtenir le signal réajusté Sr. Ce filtrage peut être du même type que celui mis en oeuvre pendant les étapes S00 et S02, mais avec une constante de temps T2 plus faible afin de réajuster le plus rapidement possible la valeur du signal Sr.

La durée de l'étape de réajustement détermine, en relation avec la fréquence Fs d'échantillonnage ou de rafraîchissement du signal Sd, le nombre de valeurs du signal Sd utilisées pour réajuster le signal Sr. Cette durée peut être choisie plus importante si aucune période de temporisation S12 ou S22 n'est prévue. Le choix de la durée des étapes de réajustement S13 ou S23 et de temporisation S12 ou S22 relève des compétences de l'homme de l'art et peut varier en fonction de l'application visée.

Au terme de l'étape de réajustement, le signal de référence Sr se trouve donc de nouveau calé sur le signal de détection Sd, ce qui permet au détecteur DCT2 de s'adapter aux conditions environnementales susceptibles de faire varier le signal de détection Sd pendant que le détecteur se trouve dans l'état de détection.

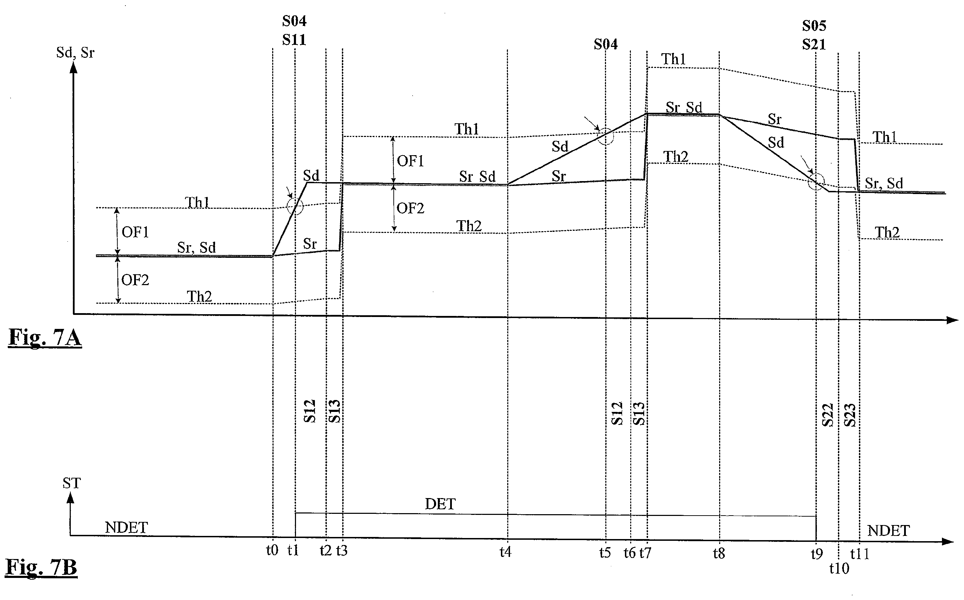

Deux exemples illustrant le fonctionnement du détecteur DTC2 seront maintenant décrits en relation avec les figures 6A, 6B et 7A, 7B qui illustrent deux scénarios différents.

Le scénario illustré sur les figures 6A, 6B correspond au cas où les paramètres environnementaux ne varient pas de manière significative pendant que le détecteur détecte un objet. On suppose dans cet exemple que les étapes de temporisation S12, S22 ne sont pas mises en oeuvre.

Le scénario illustré sur les figures 7A, 7B correspond au cas où une variation soudaine des paramètres environnementaux intervient pendant que le détecteur détecte un objet.

Les figures 6A, 7A montrent les signaux Sd, Sr et les seuils Th1, Th2. Les figures 6B, 7B montrent la valeur DET ou NDET du signal d'état ST à différents instants.

### Scénario 1, Fig. 6A, 6B

A un instant t0, un objet s'approche du détecteur et la valeur du signal Sd commence à croître. Le signal Sr varie peu en raison de la constante de temps du filtrage, cette variation n'ayant pas été représentée sur la figure 6A dans un souci de simplicité. A un instant t1, la valeur du signal Sd franchit le seuil Th1, ce qui est détecté à l'étape S04 et provoque le passage du détecteur dans l'état DET à l'étape S11 (les étapes S04, S11 étant considérées ici comme quasi-simultanées). Entre l'instant t1 et un instant t2, le détecteur exécute l'étape de réajustement S13 et le signal Sd est ramené à une valeur sensiblement égale à celle du signal Sr à la fin de l'étape S13. Le signal Sd repasse donc sous le seuil Th1. A un instant t3, l'objet s'éloigne du détecteur et la valeur du signal Sd commence à diminuer. A un instant t4, la valeur du signal Sd franchit le seuil Th2, ce qui est détecté à l'étape S05 et provoque le passage du détecteur dans l'état NDET à l'étape S21. Entre l'instant t4 et un instant t5, le détecteur exécute l'étape de réajustement S23 et le signal Sd est de nouveau ramené à une valeur sensiblement égale à celle du signal Sr à la fin de l'étape S23.

On constate donc que le détecteur présente une réponse hystérétique (i.e. à hystérésis) avec ajustement automatique du signal Sr en tant que seuil de détection central autour duquel sont articulés les seuils de détection Th1, Th2 définissant cette réponse hystérétique. En l'absence de variations soudaine des paramètres environnementaux pendant la phase de détection d'objet, cette réponse hystérétique avec ajustement automatique du seuil central n'offre pas d'effet technique nouveau relativement au procédé illustré sur les figures 2A, 2B. Il en est autrement dans le cas du scénario illustré sur les figures 7A, 7B, qui sera maintenant décrit.

### Scénario 2, Fig. 7A, 7B

A un instant t0, un objet s'approche du détecteur et la valeur du signal Sd commence à croître, tandis que le signal Sr ne change pas de manière sensible en raison de la constante de temps du filtrage. A un instant t1, la valeur du signal Sd franchit le seuil Th1, ce qui est détecté à l'étape S04 et provoque le passage du détecteur dans l'état DET à l'étape S11. Entre l'instant t1 et un instant t2, le détecteur marque un temps d'attente (étape S12) afin de laisser le signal Sd se stabiliser. Entre l'instant t2 et un instant t3, le détecteur exécute l'étape de réajustement S13 et le signal Sd est ramené à une valeur sensiblement égale à celle du signal Sr à la fin de l'étape S13. Le signal Sd repasse donc sous le seuil Th1.

A un instant t4, l'objet étant toujours présent, les paramètres environnementaux se modifient et provoque une hausse de la valeur du signal de détection Sd, qui commence à augmenter, tandis que le signal Sr ne change pas de manière sensible en raison de la constante de temps du filtrage. A un instant t5, la valeur du signal Sd franchit de nouveau le seuil Th1, ce qui est détecté à l'étape S04 sans provoquer un changement de l'état du détecteur puisque celui-ci est déjà dans l'état DET (passage direct de l'étape S10 à l'étape S12). Entre l'instant t5 et un instant t6, le détecteur marque un temps d'attente (étape S12) afin de laisser le signal Sd se stabiliser. Entre l'instant t6 et un instant t7, le détecteur exécute l'étape de réajustement S13 et le signal Sd est de nouveau ramené à une valeur sensiblement égale à celle du signal Sr à la fin de l'étape S13. Le signal Sd repasse donc sous le seuil Th1.

A un instant t8, l'objet s'éloigne du détecteur et la valeur du signal Sd commence à diminuer, tandis que les nouveaux paramètres environnementaux continuent d'agir sur le signal Sd. A un instant t9, la valeur du signal Sd franchit le seuil Th2, ce qui est détecté à l'étape S05 et provoque le passage du détecteur dans l'état NDET à l'étape S21. Entre l'instant t9 et un instant t10, le détecteur marque un temps d'attente (étape S22) afin de laisser le signal Sd se stabiliser. Entre l'instant t10 et un instant t11, le détecteur exécute l'étape de réajustement S23 et le signal Sd est de nouveau ramené à une valeur sensiblement égale à celle du signal Sr à la fin de l'étape S23.

Par contraste avec l'exemple représenté sur les figures 3A, 3B, cet exemple montre que la réponse hystérétique du détecteur avec ajustement automatique du signal de référence Sr, permet à celui-ci de s'adapter automatiquement aux variations des paramètres environnementaux sans que cela affecte son aptitude à détecter des variations du signal Sd représentatives d'un rapprochement ou d'un éloignement de l'objet à détecter.

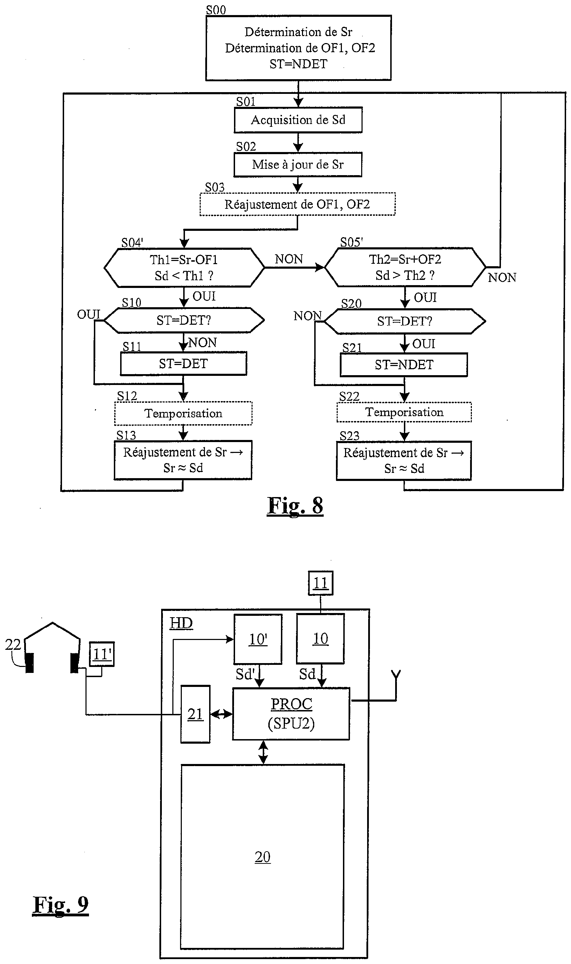

La figure 8 est un organigramme qui décrit une variante de réalisation du procédé dans le cas où le capteur 10 fournit un signal de détection Sd dont la valeur décroît lorsque l'objet se rapproche du capteur. Ce procédé est équivalent à celui de la figure 5 et ne comporte qu'une inversion de la position des seuils Th1, Th2, le seuil Th1 étant agencé en dessous du signal de référence et le seuil Th2 agencé au-dessus du signal Sr. Ainsi, les étapes représentées sur la figure 8 sont identiques à celles de la figure 5 à l'exception de l'étape S04, qui est remplacée par une étape S04', et de l'étape S05, qui est remplacée par une étape S05'.

A l'étape S04', l'unité SPU2 calcule le seuil Th1 et détermine si la valeur courante du signal de détection Sd est inférieure à ce seuil. Le seuil Th1 est calculé ici en retranchant l'offset OF1 à la valeur courante du signal de référence Sr, soit Th1=Sr-OF1. Si le signal Sd est inférieur à Th1, l'unité SPU2 va à l'étape S10, sinon à l'étape S05'.

A l'étape S05', l'unité SPU2 calcule le seuil Th2 et détermine si la valeur courante du signal de détection Sd est supérieure à ce seuil. Le seuil Th2 est calculé en ajoutant l'offset OF2 à la valeur courante du signal Sr, soit Th2=Sr+OF2. Si le signal Sd est supérieur à Th2, l'unité SPU2 va à l'étape S20, sinon retourne à l'étape S01.

Il apparaîtra clairement à l'homme de l'art que le procédé de l'invention peut être mis en oeuvre avec tout type de capteur de proximité, y compris optique, fournissant un signal de détection présentant une valeur qui croît, ou respectivement décroît, en fonction de la proximité de l'objet détecté. Le procédé offre un avantage particulier lorsque la valeur du signal de détection est sensible à des paramètres environnementaux.

Par ailleurs, le terme "filtrage" désigne dans la présente demande tout type de traitement numérique ou analogique permettant de filtrer les variations rapides du signal Sd pour obtenir un signal de référence Sr qui suit, avec un temps de retard, les variations lentes du signal Sd, et qui présente donc la même valeur que le signal Sd lorsque celui-ci ne fluctue pas. Des méthodes basées par exemple sur un calcul de la valeur moyenne pondérée d'échantillons du signal Sd pourraient permettre également de fournir le signal Sd.

Un détecteur selon l'invention est également susceptible de divers modes de réalisation et applications. L'unité SPU2 n'est pas nécessairement une unité de calcul dédiée et peut être le processeur d'un objet portatif dans lequel le capteur 10 est incorporé. Dans ce cas, la mise en oeuvre du procédé selon l'invention nécessite seulement la fourniture au processeur d'un programme comprenant un code exécutable lui permettant de mettre en oeuvre le procédé.

Par ailleurs, un détecteur selon l'invention peut être conçu pour former un détecteur de toucher. Le terme "détection de proximité" englobe, dans la présente demande, le terme "détection de toucher".

La figure 9 représente schématiquement un objet portatif HD comprenant un processeur PROC et des organes 20, 21 contrôlés par le processeur. L'organe 20 est par exemple un écran tactile et l'organe 21 est par exemple un amplificateur audiofréquence destiné à être connecté à un casque 22. Le processeur PROC est par exemple le processeur bande de base d'un téléphone mobile, le processeur d'un baladeur audio ou d'un PDA.

L'objet portatif HD est équipé d'un premier capteur de proximité 10 et d'un second capteur de proximité 10'. Le capteur 10 a une partie sensible 11 qui est agencée pour détecter la présence d'une partie du corps à proximité de l'objet portatif HD, par exemple la tête de l'utilisateur. Le capteur 10' a une partie sensible 11' qui est agencée dans le casque, pour détecter si le casque est porté ou non par l'utilisateur.

Le processeur PROC est utilisé comme unité de traitement SPU2 et reçoit un programme de mise en oeuvre d'un procédé de traitement selon l'invention des signaux de détection Sd, Sd' fournis par les capteurs 10, 10'. Le processeur PROC est également configuré pour activer ou désactiver les organes 20 et 21 en fonction de l'état DET ou NDET qu'il détermine, pour chaque capteur 10, 10', à partir des signaux Sd, Sd'. Ainsi, si l'organe 20 est un écran tactile, le processeur PROC est configuré pour verrouiller l'écran lorsqu'il détecte, au moyen du capteur 10, que l'utilisateur a placé l'objet portatif contre sa tête. Si l'organe 21 est un amplificateur audio, le processeur PROC est configuré pour activer l'amplificateur lorsqu'il détecte, au moyen du capteur 10', que l'utilisateur a posé le casque sur sa tête.

## Revendications

1. Procédé de détection d'objet au moyen d'un signal de détection (Sd) fourni par un capteur (10) de proximité, le signal de détection présentant une valeur qui croit, ou respectivement décroît, en fonction de la proximité d'un objet détecté, procédé comprenant des étapes consistant à :
- générer un signal de référence (Sr),
- définir un premier seuil de détection (Th1) relativement au signal de référence (Sr),
- passer d'un état de non-détection d'objet (NDET) à un état de détection d'objet (DET) lorsque la valeur du signal de détection (Sd) devient supérieure, ou respectivement inférieure, au premier seuil de détection (Th1),
**caractérisé en ce que** le signal de référence est généré par filtrage des variations rapides de la valeur du signal de détection (Sd) dépendant des paramètres environnementaux et **en ce que** le procédé comprend l'étape consistant à :
- lorsque la valeur du signal de détection devient supérieure, ou respectivement inférieure, au premier seuil de détection (Th1), réajuster la valeur du signal de référence (Sr) de manière que la valeur du signal de détection (Sd) redevienne inférieure, ou respectivement supérieure, au premier seuil de détection (Th1).

2. Procédé selon la revendication 1, comprenant une étape consistant à réajuster de nouveau la valeur du signal de référence (Sr) de manière que la valeur du signal de détection (Sd) redevienne inférieure, ou respectivement supérieure, au premier seuil de détection (Th1), lorsque, dans l'état de détection d'objet (DET), la valeur du signal de détection devient de nouveau supérieure, ou respectivement inférieure, au premier seuil de détection (Th1).

3. Procédé selon l'une des revendications 1 et 2, comprenant les étapes consistant à :
- définir un second seuil de détection (Th2) relativement au signal de référence (Sr),
- passer de l'état de détection d'objet (DET) à l'état de non-détection d'objet (NDET) lorsque la valeur du signal de détection devient inférieure, ou respectivement supérieure, au second seuil de détection (Th2), et
- lorsque la valeur du signal de détection devient inférieure, ou respectivement supérieure, au second seuil de détection (Th2), réajuster la valeur du signal de référence (Sr) de manière que la valeur du signal de détection (Sd) redevienne supérieure, ou respectivement inférieure, au second seuil de détection (Th2).

4. Procédé selon la revendication 3, comprenant une étape consistant à réajuster de nouveau la valeur du signal de référence (Sr) de manière que la valeur du signal de détection (Sd) redevienne supérieure, ou respectivement inférieure, au second seuil de détection (Th2), lorsque, dans l'état de non-détection d'objet (NDET), la valeur du signal de détection devient de nouveau inférieure, ou respectivement supérieure, au second seuil de détection (Th2), sans modifier l'état de non-détection.

5. Procédé selon l'une des revendications 3 et 4, dans lequel le second seuil de détection (Th2) est égal à la valeur du signal de référence (Sr) à laquelle est soustrait un offset (OF2), ou respectivement à laquelle est ajouté un offset (OF2).

6. Procédé selon l'une des revendications 1 à 5, dans lequel le premier seuil de détection (Th1) est égal à la valeur du signal de référence (Sr) à laquelle est ajouté un offset (OF1), ou respectivement à laquelle est soustrait un offset (OF1).

7. Procédé selon l'une des revendications 1 à 6, dans lequel le réajustement de la valeur du signal de référence (Sr) est conduit de manière que la valeur du signal de détection (Sd) soit sensiblement égale à la valeur du signal de référence (Sr) avec une déviation maximale inférieure à l'écart (OF1, OF2) entre la valeur du signal de référence réajusté (Sr) et le seuil de détection (Th1, Th2) dont le franchissement provoque le réajustement du signal de référence.

8. Procédé selon l'une des revendications 1 à 7, dans lequel le réajustement de la valeur du signal de référence (Sr) est réalisé à partir de valeurs du signal de détection (Sd) postérieures à l'instant où la valeur du signal de détection devient supérieure ou inférieure au seuil (Th1, Th2).

9. Procédé selon l'une des revendications 1 à 8, dans lequel la valeur du signal de détection est une amplitude, une fréquence, une phase, une durée ou un nombre.

10. Procédé selon l'une des revendications 1 à 9, dans lequel l'étape consistant à passer de l'état de détection d'objet (DET) à l'état de non-détection d'objet (NDET) ou vice-versa, comprend une étape consistant à modifier la valeur d'un signal d'état (ST) ou d'un registre d'état.

11. Procédé selon l'une des revendications 1 à 10, dans lequel l'objet à détecter est une partie du corps humain.

12. Procédé selon l'une des revendications 1 à 11, dans lequel le signal de détection (Sd) est fourni par un capteur de proximité capacitif.

13. Produit-programme d'ordinateur, comprenant un code exécutable enregistré sur un support pour la mise en oeuvre du procédé selon l'une des revendications 1 à 10.

14. Détecteur (DV2) de proximité comprenant :
- un capteur (10, 11) de proximité fournissant un signal de détection (Sd) présentant une valeur qui croît, ou respectivement décroît, lorsqu'un objet se rapproche du capteur ou touche le capteur,
- une unité de traitement (SPU2), à microprocesseur ou à logique câblée, recevant le signal de détection (Sd), **caractérisé en ce que** l'unité de traitement (SPU2) est configurée pour mettre en oeuvre le procédé selon l'une des revendications 1 à 10.

15. Dispositif portatif (HD) présentant au moins un organe (20, 21) pouvant être activé et désactivé, **caractérisé en ce qu'**il comprend au moins un détecteur (10, 10', PROC) selon la revendication 14 et **en ce qu'**il est configuré pour activer ou désactiver l'organe lorsqu'un objet est détecté à proximité du dispositif.

## Patentansprüche

1. Verfahren zum Erfassen eines Objekts mit einem von einem Näherungssensor (10) gelieferten Erfassungssignal (Sd), wobei das Erfassungssignal einen Wert aufweist, der entsprechend der Nähe eines erfassten Objekts ansteigt bzw. abfällt, wobei das Verfahren Schritte umfasst zum:
- Erzeugen eines Referenzsignals (Sr),
- Definieren einer ersten Erfassungsschwelle (Th1) in Bezug auf das Referenzsignal (Sr),
- Wechseln von einem Objekt-Nichterfassungszustand (NDET) zu einem Objekterfassungszustand (DET), wenn der Wert des Erfassungssignals (Sd) die erste Erfassungsschwelle (Th1) überschreitet bzw. unterschreitet,
**dadurch gekennzeichnet, dass** das Referenzsignal durch Filtern der schnellen Änderungen des Werts des Erfassungssignals (Sd) abhängig von Umweltparametern erzeugt wird und dass das Verfahren den Schritt erfasst zum:
- wenn der Wert des Erfassungssignals die erste Erfassungsschwelle (Th1) überschreitet bzw. unterschreitet, Nachstellen des Werts des Referenzsignals (Sr), so dass der Wert des Erfassungssignals (Sd) die erste Erfassungsschwelle (Th1) wieder unterschreitet bzw. überschreitet.

2. Verfahren nach Anspruch 1, umfassend einen Schritt zum erneuten Nachstellen des Werts des Referenzsignals (Sr), so dass der Wert des Erfassungssignals (Sd) die erste Erfassungsschwelle (Th1) wieder unterschreitet bzw. überschreitet, wenn im Objekterfassungszustand (DET) der Wert des Erfassungssignals die erste Erfassungsschwelle (Th1) wieder überschreitet bzw. unterschreitet.

3. Verfahren nach Anspruch 1 oder 2, umfassend die Schritte zum:
- Definieren einer zweiten Erfassungsschwelle (Th2) in Bezug auf das Referenzsignal (Sr),
- Wechseln vom Objekterfassungszustand (DET) zum Objekt-Nichterfassungszustand (NDET), wenn der Wert des Erfassungssignals die zweite Erfassungsschwelle (Th2) unterschreitet bzw. überschreitet, und
- wenn der Wert des Erfassungssignals die zweite Erfassungsschwelle (Th2) unterschreitet bzw. überschreitet, Nachstellen des Werts des Referenzsignals (Sr), so dass der Wert des Erfassungssignals (Sd) die zweite Erfassungsschwelle (Th2) wieder überschreitet bzw. unterschreitet.

4. Verfahren nach Anspruch 3, umfassend einen Schritt zum erneuten Nachstellen des Werts des Referenzsignals (Sr), so dass der Wert des Erfassungssignals (Sd) die zweite Erfassungsschwelle (Th2) wieder überschreitet bzw. unterschreitet, wenn im Objekt-Nichterfassungszustand (NDET) der Wert des Erfassungssignals die zweite Erfassungsschwelle (Th2) wieder unterschreitet bzw. überschreitet, ohne den Nichterfassungszustand zu ändern.

5. Verfahren nach Anspruch 3 oder 4, wobei die zweite Erfassungsschwelle (Th2) dem Wert des Referenzsignals (Sr) entspricht, von dem ein Offset (OF2) abgezogen wird bzw. zu dem ein Offset (OF2) hinzugefügt wird.

6. Verfahren nach einem der Ansprüche 1 bis 5, wobei die erste Erfassungsschwelle (Th1) dem Wert des Referenzsignals (Sr) entspricht, zu dem ein Offset (OF1) hinzugefügt wird bzw. von dem ein Offset (OF1) abgezogen wird.

7. Verfahren nach einem der Ansprüche 1 bis 6, wobei das Nachregeln des Werts des Referenzsignals (Sr) so durchgeführt wird, dass der Wert des Erfassungssignals (Sd) im Wesentlichen dem Signal des Referenzsignals (Sr) mit einer maximalen Abweichung unter dem Abstand (OF1, OF2) zwischen dem Wert des nachgestellten Referenzsignals (Sr) und der Erfassungsschwelle (Th1, Th2), deren Überschreiten das Nachstellen des Referenzsignals bewirkt, entspricht.

8. Verfahren nach einem der Ansprüche 1 bis 7, wobei das Nachstellen des Werts des Referenzsignals (Sr) aufgrund von Werten des Erfassungssignals (Sd) nach dem Zeitpunkt erfolgt, zu dem der Wert des Erfassungssignals die Schwelle (Th1, Th2) überschreitet oder unterschreitet.

9. Verfahren nach einem der Ansprüche 1 bis 8, wobei der Wert des Erfassungssignals eine Amplitude, eine Frequenz, eine Phase, eine Dauer oder eine Zahl ist.

10. Verfahren nach einem der Ansprüche 1 bis 9, wobei der Schritt zum Wechseln vom Objekterfassungszustand (DET) zum Objekt-Nichterfassungszustand (NDET) oder umgekehrt einen Schritt zum Ändern des Werts eines Zustandssignals (ST) oder eines Zustandsregisters umfasst.

11. Verfahren nach einem der Ansprüche 1 bis 10, wobei das zu erfassende Objekt ein Teil des menschlichen Körpers ist.

12. Verfahren nach einem der Ansprüche 1 bis 11, wobei das Erfassungssignal (Sd) von einem kapazitiven Näherungssensor geliefert wird.

13. Computerprogrammprodukt umfassend einen auf einem Träger gespeicherten ausführbaren Code zum Ausführen des Verfahrens nach einem der Ansprüche 1 bis 10.

14. Näherungsschalter (DV2) umfassend:
- einen ein einen Wert, der ansteigt bzw. abfällt, wenn sich ein Objekt dem Sensor nähert oder den Sensor berührt, aufweisendes Erfassungssignal (Sd) liefernden Sensor (10, 11),
- eine das Erfassungssignal (Sd) empfangende Verarbeitungseinheit (SPU2) mit Mikroprozessor oder verdrahteter Logik,
**dadurch gekennzeichnet, dass** die Verarbeitungseinheit (SPU2) zum Ausführen des Verfahrens nach einem der Ansprüche 1 bis 10 ausgebildet ist.

15. Wenigstens ein aktivierbares oder deaktivierbares Element (20, 21) aufweisende tragbare Vorrichtung (HD), **dadurch gekennzeichnet, dass** sie wenigstens einen Schalter (10, 10', PROC) nach Anspruch 14 umfasst und dass sie zum Aktivieren oder Deaktivieren des Elements, wenn ein Objekt in der Nähe der Vorrichtung erfasst wird, ausgebildet ist.

## Claims

1. Method for detecting an object by means of a detection signal (Sd) delivered by a proximity sensor (10), the detection signal exhibiting a value that increases or decreases, respectively, according to the proximity of a detected object, which method comprises steps consisting in:
- generating a reference signal (Sr);
- defining a first detection threshold (Th1) in relation to the reference signal (Sr);
- transitioning from a no object detected state(NDET) state to an object detected state (DET) when the value of the detection signal (Sd) becomes higher or lower, respectively, than the first detection threshold (Th1),
**characterized in that** the reference signal is generated by filtering the rapid variations in the value of the detection signal (Sd) depending on the environmental parameters and **in that** the method comprises the step consisting in:
- when the value of the detection signal becomes higher or lower, respectively, than the first detection threshold (Th1), the value of the reference signal (Sr) is readjusted such that the value of the detection signal (Sd) again becomes lower or higher, respectively, than the first detection threshold (Th1).

2. Method according to Claim 1, comprising a step consisting in again readjusting the value of the reference signal (Sr) such that the value of the detection signal (Sd) again becomes lower or higher, respectively, than the first detection threshold (Th1) when, in the object detected state (DET), the value of the detection signal again becomes higher or lower, respectively, than the first detection threshold (Th1).

3. Method according to either of Claims 1 and 2, comprising the steps consisting in:
- defining a second detection threshold (Th2) in relation to the reference signal (Sr);
- transitioning from the object detected state (DET) to the no object detected state (NDET) when the value of the detection signal becomes lower or higher, respectively, than the second detection threshold (Th2); and
- when the value of the detection signal becomes lower or higher, respectively, than the second detection threshold (Th2), the value of the reference signal (Sr) is readjusted such that the value of the detection signal (Sd) again becomes higher or lower, respectively, than the second detection threshold (Th2) .

4. Method according to Claim 3, comprising a step consisting in again readjusting the value of the reference signal (Sr) such that the value of the detection signal (Sd) again becomes higher or lower, respectively, than the second detection threshold (Th2) when, in the no object detected state (NDET), the value of the detection signal again becomes lower or higher, respectively, than the second detection threshold (Th2), without modifying the no object detected state.

5. Method according to either of Claims 3 and 4, wherein the second detection threshold (Th2) is equal to the value of the reference signal (Sr) from which an offset (OF2) is subtracted or to which an offset (OF2) is added, respectively.

6. Method according to one of Claims 1 to 5, wherein the first detection threshold (Th1) is equal to the value of the reference signal (Sr) to which an offset (OF1) is added or from which an offset (OF1) is subtracted, respectively.

7. Method according to one of Claims 1 to 6, wherein the value of the reference signal (Sr) is readjusted such that the value of the detection signal (Sd) is substantially equal to the value of the reference signal (Sr) with a maximum deviation that is smaller than the difference (OF1, OF2) between the value of the readjusted reference signal (Sr) and the detection threshold (Th1, Th2), the crossing of which results in the reference signal being readjusted.

8. Method according to one of Claims 1 to 7, wherein the value of the reference signal (Sr) is readjusted on the basis of values of the detection signal (Sd) subsequent to the instant in time at which the value of the detection signal becomes higher or lower than the threshold (Th1, Th2).

9. Method according to one of Claims 1 to 8, wherein the value of the detection signal is an amplitude, a frequency, a phase, a duration or a number.

10. Method according to one of Claims 1 to 9, wherein the step consisting in transitioning from the object detected state (DET) to the no object detected state (NDET), or vice versa, comprises a step consisting in modifying the value of a state signal (ST) or of a state register.

11. Method according to one of Claims 1 to 10, wherein the object to be detected is a part of the human body.

12. Method according to one of Claims 1 to 11, wherein the detection signal (Sd) is delivered by a capacitive proximity sensor.

13. Computer program product, comprising an executable code recorded on a medium for implementing the method according to one of Claims 1 to 10.

14. Proximity detector (DV2) comprising:
- a proximity sensor (10, 11) delivering a detection signal (Sd) exhibiting a value that increases or decreases, respectively, when an object approaches the sensor or touches a sensor;
- a microprocessor- or hardwired logic-based processing unit (SPU2) receiving the detection signal (Sd),
**characterized in that** the processing unit (SPU2) is configured to implement the method according to one of claims 1 to 10.

15. Portable device (HD) having at least one member (20, 21) that may be activated or deactivated, **characterized in that** it comprises at least one detector (10, 10', PROC) according to Claim 14 and **in that** it is configured to activate or to deactivate the member when an object is detected in proximity to the device.
